# EUROPEAN PATENT APPLICATION

(11) **EP 4 418 053 A1**
(43) Date of publication of application: **21.08.2024**
(21) Application number: 23163316.5
(22) Date of filing: 21.03.2023
(51) Int. Cl.: G04F 10/00

(54) **APPARATUS FOR CLOCKLESS AND DIRECT CONVERSION OF TIME INTERVAL TO DIGITAL WORD**

(30) Priority: 16.02.2023 PL 44380923
(71) Applicant: Akademia Gorniczo-Hutnicza im. Stanislawa Staszica w Krakowie, 30-059 Krakow (PL)
(72) Inventor: Koscielnik, Dariusz, 31-431 Kraków (PL); Jurasz, Konrad, 34-331 Swinna (PL); Szyduczynski, Jakub, 22-460 Szczebrzeszyn (PL)
(74) Representative: Wlasienko, Jozef

(57) **Abstract**

An apparatus for clockless and direct conversion of a time interval to a digital word comprises: a control module (CM), two comparators (K_{R}, K_{S}), two current sources (I_{R}, I_{S}), two buses (R, S), two counter capacitors Cₙ₋ᵣ, a set of n-r capacitors (Cₙ₋ᵣ₋₁, ..., C₀) with a binary capacitance ratio, two counter switches (Sₙ₋ᵣ) and n-r switches of a set (Sₙ₋ᵣ₋₁, ..., S₀). The control module (CM) is equipped with an r-bit counter (Ct), whose outputs are connected directly to outputs of r most significant bits (bₙ₋₁, ..., bᵣ) of the n-bit output digital word (B).

## Description

The subject of the invention is an apparatus for clockless and direct conversion of a time interval to a digital word that can be applied in monitoring and control systems that require very high energy efficiency, such as biomedical equipment and mobile devices.

An apparatus for direct conversion of a the time interval to a digital word is known from the patent specification US 9612581 B1. This apparatus comprises a set of n capacitors having binary scaled capacitances, wherein n is the number of bits of the output digital word. Capacitance of each subsequent capacitor of the set is twice as low as the capacitance of its immediately preceding capacitor. Total capacitance of used capacitors is therefore (2ⁿ-1)·C₀, wherein capacitance C₀, called unit capacitance, is the capacitance of the capacitor with the lowest capacitance in the set of capacitors. An area occupied by the set of capacitors in a monolithic system is on the other hand directly proportional to the total capacitance of the capacitors of this set. A bottom plate of each capacitor of the set of capacitors is connected to a ground of the circuit, and a top plate of each capacitor of the set of capacitors is connected to a moving contact of a switch of the set, assigned to this capacitor. A first stationary contact of each switch of the set is connected to a reference bus, a second stationary contact of each switch of the set is connected to the ground of the circuit, and a third stationary contact of each switch of the set is connected to a signal bus. The apparatus furthermore comprises a control module equipped with a converted time interval input, an output for signaling complete conversion, a reference input connected to an output of a reference comparator and a signal input connected to an output of a signal comparator. The control module is also equipped with a reference output connected to a control input of a reference current source and a signal output connected to a control input of a signal current source, as well as outputs that control switches of the set and an output of n-bit output digital word. A non-inverting input of the reference comparator which monitors voltage building up across a capacitor charged by of the reference current source, is connected to the reference bus and to an output of the reference current source. An input of this current source is connected to supply voltage. An inverting input of the reference comparator is connected to threshold voltage. A non-inverting input of the signal comparator which monitors voltage building up across a capacitor charged by the signal current source, is connected to the signal bus and to an output of the signal current source, an input of this current source is connected to the supply voltage. An inverting input of the signal comparator is connected to the threshold voltage and to the inverting input of the reference comparator.

The task of the invention is to provide an apparatus for clockless and direct conversion of a time interval to a digital word, destined for using in control and monitoring systems with high energy efficiency.

An apparatus for clockless and direct conversion of a time interval to a the digital word, according to the invention, comprises a control module equipped with a converted time interval input, a complete conversion output, a reference input connected to an output of a reference comparator and a signal input connected to an output of a signal comparator. The control module is furthermore equipped with a reference output connected to a control input of a reference current source and a signal output connected to a control input of a signal current source, as well as control outputs connected to control inputs of switches of a set and an output of n-bit output digital word. The output digital word comprises, in turn, r most significant bits and n-r least significant bits, where r is a linearization degree.

A non-inverting input of the reference comparator is connected to a reference bus and to an output of the reference current source. An input of the reference current source is connected to supply voltage. An inverting input of the reference comparator is connected to threshold voltage. A non-inverting input of the signal comparator is connected to a signal bus and to an output of the signal current source, an input of the signal current source is connected to supply voltage. An inverting input of the signal comparator is connected to the threshold voltage and to the inverting input of the reference comparator.

A set of capacitors comprises n-r capacitors, and capacitance of each subsequent capacitor of the set of capacitors is twice as low as the capacitance of its immediately preceding capacitor. A bottom plate of each capacitor of the set of capacitors is connected to a ground of the circuit. A top plate of each capacitor of the set of capacitors is connected to a moving contact of a switch of the set, assigned to this capacitor. A first stationary contact of each switch of the set is connected to the reference bus. A second stationary contact of each switch of the set is connected to the ground of the circuit. A third stationary contact of each switch of the set is, in turn, connected to the signal bus.

The essence of the invention is that the control module comprises an r-bit counter, whose outputs are connected to outputs of r most significant bits of the output digital word. The control module is furthermore equipped with counter outputs, each of which is connected to a control input of a different counter switch. To a moving contact of each counter switch a top plate of a different counter capacitor is connected. A first stationary contact of each counter switch is connected to the reference bus, and a second stationary contact of each counter switch is connected to the ground of the circuit. To the ground of the circuit a bottom plate of each counter capacitor is also connected. Capacitance of each counter capacitor is the same.

It is advantageous if the linearization degree r is a natural number, greater than one and less than the number n of bits of the output digital word.

It is also advantageous if the apparatus comprises two counter capacitors.

It is advantageous if efficiency of the reference current source is the same as efficiency of the signal current source. At the same time capacitance of each counter capacitor is twice as high as capacitance of the capacitor with the highest capacitance in the set of capacitors.

It is also advantageous if efficiency of the reference current source is controlled. Efficiency of the reference current source is kept by means of the control module at a value k-times lower than efficiency of the signal current source or equal to the efficiency of the signal current source. Simultaneously, capacitance of each counter capacitor is k-times lower than double capacitance of the capacitor with the highest capacitance in the set of capacitors.

The advantage of the solution consists in maintaining a self-clocking capability of the entire conversion process, which does not require the use of an energy-intensive clock signal source. In the solution a permanent connection of bottom plates of all capacitors to the ground of the circuit is also provided. As a result of the above, the influence of most parasitic capacitances on accuracy of obtained results of the conversion process is eliminated or significantly limited.

As a result of repeated using the same two counter capacitors in the apparatus, the number of necessary of capacitors and accompanying switches has been reduced. From among the capacitors used in the known solution those with the largest capacitances and occupying the largest area in the monolithic structure have become redundant. For the linearization coefficient r = 2, 3, 4 the total capacitance of necessary capacitors is reduced by 25 %, 62.5 %, 81.25 %, respectively. An area occupied by these elements in the monolithic system is reduced to the same extent. The amount of energy drawn from a power source and associated with filling the capacitors is also reduced. For the linearization coefficient r = 2, 3, 4 its average value is decreased by 28.75%, 32.81%, 41.02%, respectively. Further increasing the value of the linearization coefficient r improves the mentioned parameters, but at the same time it leads to increased reuse of the counter capacitors and the resulting increase in dynamic energy consumption. The average number of system state switchovers, which in the known solution is always n+1, for the linearization coefficient r = 2, 3, 4 is increased by 0.25, 1.375, 4.438, respectively.

The use of the reference current source with reduced efficiency allows for multiple capacitance reduction of both counter capacitors, which otherwise constitutes more than two-thirds of the total capacitance of all necessary capacitors. The amount of area and energy required by the counter capacitors decreases proportionally to temporary efficiency reduction of the reference current source.

The subject of the invention is explained in embodiments in the drawing presenting:
- Fig. 1 -: an apparatus in idle state awaiting a beginning of a converted time interval,
- Fig. 2 -: mutual relationships between a reference time period RT and a signal time period ST for a converted time interval of a length that does not use full capacity of a counter Ct.
- Fig. 3 -: mutual relationships between a reference time period RT and a signal time period ST for a converted time interval of a length that uses full capacity of a 3-bit counter Ct.

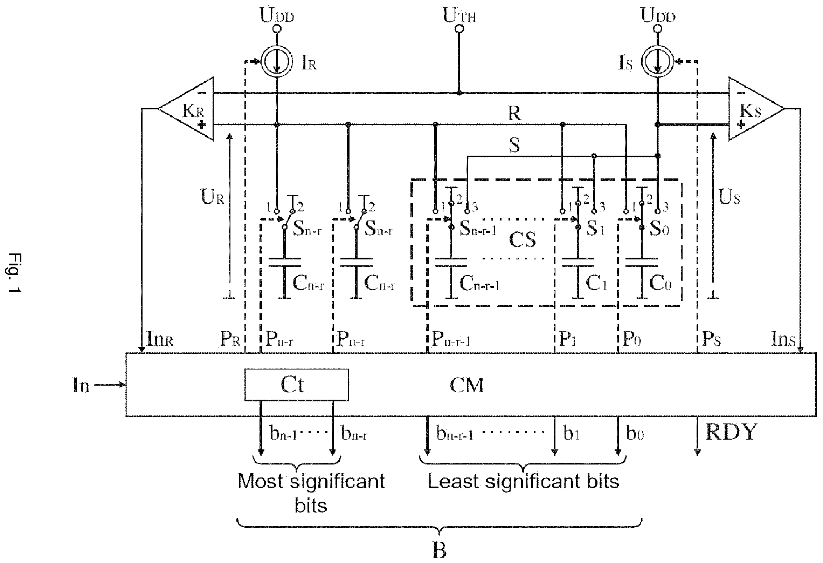

According to the invention, an apparatus for clockless and direct conversion of a time interval to a digital word, in a first exemplary solution (Fig. 1), comprises a control module CM equipped with a converted time interval input In, a complete conversion output RDY, a reference input In_{R} and a signal input Ins. The control module CM is furthermore equipped with a reference output P_{R}, a signal output Ps, control outputs Pₙ₋ᵣ₋₁, ..., P₀, two counter outputs Pₙ₋ᵣ and an output of n-bit output digital word B. The output digital word B comprises r most significant bits bₙ₋₁, ..., bᵣ and n-r least significant bits bₙ₋ᵣ₋₁, ..., b₀. The parameter r is a linearization degree, and its most advantageous values are: 2, 3 or 4. The control module CM comprises also an r-bit counter Ct, whose outputs are connected to outputs of r most significant bits bₙ₋₁, ..., bₙ₋ᵣ of the output digital word B.

The reference input In_{R} of the control module CM is connected to an output of a reference comparator K_{R}, and the signal input Ins of the control module CM is connected to an output of a signal comparator Ks. The reference output P_{R} of the control module CM is connected to a control input of a reference current source I_{R}, and the signal output P_{S} of the control module CM is connected to a control input of a signal current source Is. In this exemplary apparatus, efficiency of the reference current source I_{R} is the same as efficiency of the signal current source Is. The control outputs Pₙ₋ᵣ₋₁, ..., P₀ of the control module CM are connected, respectively, to control inputs of switches of a set Sₙ₋ᵣ₋₁, ..., S₀. Each counter output Pₙ₋ᵣ of the control module CM is connected to a control input of a different one of two counter switches Sₙ₋ᵣ.

A non-inverting input of the reference comparator K_{R} is connected to a reference bus R and to an output of the reference current source I_{R}, whose input is connected to supply voltage U_{DD}. An inverting input of the reference comparator K_{R} is connected to threshold voltage U_{TH}. A non-inverting input of the signal comparator Ks is connected to a signal bus S and to an output of the signal current source Is, whose input is connected to the supply voltage U_{DD}. An inverting input of the signal comparator Ks is connected to the threshold voltage U_{TH} and to the inverting input of the reference comparator K_{R}.

A set of capacitors CS comprises n-r capacitors Cₙ₋ᵣ₋₁, ..., C₀, and capacitance of each subsequent capacitor Cₙ₋ᵣ₋₁, ..., C₀ of the set of capacitors CS is twice as low as the capacitance of its immediately preceding capacitor. A bottom plate of each capacitor Cₙ₋ᵣ₋₁, ..., C₀ of the set of capacitors CS is connected to a ground of the circuit. In this exemplary apparatus, capacitance of each of two counter capacitors Cₙ₋ᵣ is the same and simultaneously is twice as high as capacitance of the capacitor Cₙ₋ᵣ₋₁ with the highest capacitance in the set of capacitors CS. A bottom plate of each of two counter capacitors Cₙ₋ᵣ is connected to the ground of the circuit.

A top plate of each capacitor Cₙ₋ᵣ₋₁, ..., C₀ of the set of capacitors CS is connected, respectively, to a moving contact of a switch of the set Sₙ₋ᵣ₋₁, ..., S₀. A first stationary contact of each switch of the set Sₙ₋ᵣ₋₁, ..., S₀ is connected to the reference bus R. A second stationary contact of each switch of the set Sₙ₋ᵣ₋₁, ..., S₀ is connected to the ground of the circuit. A third stationary contact of each switch of the set Sₙ₋ᵣ₋₁, ..., S₀ is, in turn, connected to the signal bus S.

A top plate of each of two counter capacitors Cₙ₋ᵣ is connected to a moving contact of a different one of the two counter switches Sₙ₋ᵣ. A first stationary contact of each counter switch Sₙ₋ᵣ is connected to the reference bus R. A second stationary contact of each counter switch Sₙ₋ᵣ is, in turn, connected to the ground of the circuit.

According to the invention, an apparatus for clockless and direct conversion of a time interval to a digital word, in a second exemplary solution, differs from the first one in that efficiency of the reference current source I_{R} is controlled. Efficiency of the reference current source I_{R} is kept by means of the control module CM at a value 5 times lower than efficiency of the signal current source Is or equal to the efficiency of the signal current source Is. Furthermore, capacitance of each counter capacitor Cₙ₋ᵣ is the same and simultaneously five times lower than double capacitance of the capacitor Cₙ₋ᵣ₋₁ with the highest capacitance in the set of capacitors CS.

In the following description of the conversion process, below notation has been adopted:
x is an index of a capacitor Cₓ from the set of capacitors CS, currently charged by the reference current source I_{R},
y is an index of a capacitor C_{y} from the set of capacitors CS, currently charged by the signal current source Is,
z is an index of a capacitor C_{z}, whose capacitance is currently the highest among those capacitors from the set of capacitors CS that have not been charged yet.

A clockless and direct conversion of a time interval to a digital word, implemented according to the invention in a first exemplary apparatus (Fig. 1), proceeds as follows. Before the conversion process is started, the control module CM causes, by means of a signal from the reference output P_{R}, switching off the reference current source I_{R}, whereas by means of a signal from the signal output P_{S} the control module CM causes switching off the signal current source Is. By means of signals from the control outputs Pₙ₋ᵣ₋₁, ..., P₀ the control module CM causes switching the switches of the set Sₙ₋ᵣ₋₁, ..., S₀ to second positions, and therefore connecting top plates of all capacitors Cₙ₋ᵣ₋₁, ..., C₀ of the set of capacitors CS to the ground of the circuit, forcing a complete discharge of all capacitors Cₙ₋ᵣ₋₁, ..., C₀ of the set of capacitors CS. By means of signals from both counter outputs Pₙ₋ᵣ the control module CM causes switching both counter switches Sₙ₋ᵣ to second position, and therefore connecting top plates of both counter capacitors Cₙ₋ᵣ to the ground of the circuit, forcing a complete discharge of both counter capacitors Cₙ₋ᵣ. Next, the control module CM starts to monitor the state of a converted time interval input In in order to detect a beginning of the converted time interval T.

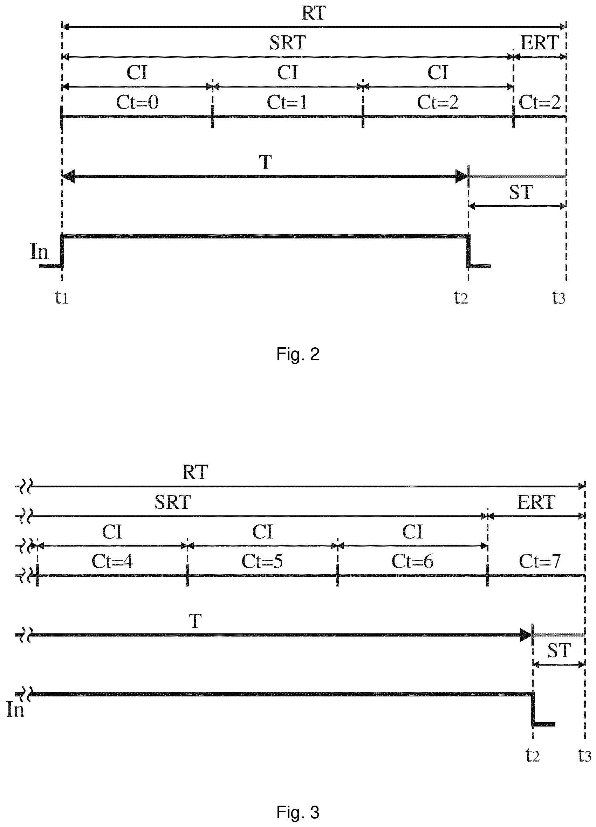

At a time instant t₁ when the beginning of the converted time interval T is detected by the control module CM, signaled at the converted time interval input In, the control module CM starts to monitor the state of the converted time interval input In in order to detect an end of the converted time interval T. At the same time, the control module CM puts a complete conversion output RDY in inactive state and resets the state of the counter Ct. Next, the control module CM starts to roughly measure an initial fragment SRT of the reference time period RT using linear method (Fig. 2). First, the control module CM selects any of two counter capacitors Cₙ₋ᵣ and a counter switch Sₙ₋ᵣ and a counter output Pₙ₋ᵣ assigned to the selected counter capacitor Cₙ₋ᵣ. Next, the control module CM causes, by means of a signal from the selected counter output Pₙ₋ᵣ, switching the selected counter switch Sₙ₋ᵣ to first position, and therefore connecting a top plate of the selected counter capacitor Cₙ₋ᵣ to the output of the reference current source I_{R}. At the same time, by means of a signal from the reference output P_{R}, the control module CM causes switching on the reference current source I_{R}. The control module CM starts to measure a counter interval CI (Fig. 2). Reference voltage U_{R} building up across the selected counter capacitor Cₙ₋ᵣ, charged by the reference current source I_{R}, is compared by means of the reference comparator K_{R} with the threshold voltage U_{TH}. When the reference voltage U_{R} reaches the threshold voltage U_{TH}, then, based on the output signal of the reference comparator K_{R}, the control module CM terminates measuring the counter interval CI. To this end, the control module CM causes, by means of a signal from the selected counter output Pₙ₋ᵣ, switching the selected counter switch Sₙ₋ᵣ to second position, and therefore disconnecting the top plate of the selected counter capacitor Cₙ₋ᵣ from the output of the reference current source I_{R} and at the same time connecting the top plate of the selected counter capacitor Cₙ₋ᵣ to the ground of the circuit, forcing a complete discharge of this capacitor.

If the control module does not detect the end of the converted time interval T during measuring the counter interval Cl, then the control module CM increments the content of the counter Ct (Fig. 2 and Fig. 3). Next, the control module CM checks new content of the counter Ct. If any of bits of this counter is zero, meaning that the counter has not reached its maximum value, then the control module CM starts to measure another counter interval CI (Fig. 2). To this end, the control module CM selects a different one of the counter capacitors Cₙ₋ᵣ than the one charged immediately before and a counter switch Sₙ₋ᵣ and a counter output Pₙ₋ᵣ assigned to this counter capacitor Cₙ₋ᵣ. By means of a signal from the selected counter output Pₙ₋ᵣ the control module CM causes switching the selected counter switch Sₙ₋ᵣ to first position, and therefore connecting a top plate of the selected counter capacitor Cₙ₋ᵣ to the output of the reference current source I_{R} and thus starting charging the selected counter capacitor Cₙ₋ᵣ. The control module CM repeats actions related to measuring the counter intervals CI until the end of measuring the counter interval Cl, during which the control module CM detects the end of the converted time interval T (Fig. 2), or when after incrementing the content of the counter Ct the control module CM checks that new content of the counter Ct consists only of bits with a value one (Fig. 3).

In both mentioned cases, to r most significant bits bₙ₋₁, ..., bₙ₋ᵣ of the output digital word B the control module CM assigns a final value by means of the outputs of the r-bit counter Ct. At the same time, the control module starts a precise measurement of a final fragment ERT of the reference time period RT by method of weight compensation (Fig. 2 and Fig. 3). First, the control module CM selects from the set of capacitors CS a capacitor C_{z}, whose capacitance is currently the highest among those capacitors Cₙ₋ᵣ₋₁, ..., C₀ of the set of capacitors CS that have not been charged yet. Next, the control module CM causes, by means of a signal from a control output P_{z}, switching a switch of a set S_{z} to first position, and therefore connecting a top plate of the capacitor C_{z} to the output of the reference current source I_{R}. The control module CM starts to measure the reference interval. The reference voltage U_{R} building up across the capacitor Cₓ, charged by the reference current source I_{R}, is compared by means of the reference comparator K_{R} with the threshold voltage U_{TH}. When the reference voltage U_{R} reaches the threshold voltage U_{TH}, then, based on the output signal of the reference comparator K_{R}, the control module CM terminates measuring the reference interval. To this end, the control module CM causes, by means of a signal from the control output Pₓ, switching a switch of a set Sₓ to second position, and therefore disconnecting a top plate of the capacitor Cₓ from the output of the reference current source I_{R} and at the same time connecting the top plate of the capacitor Cₓ to the ground of the circuit, forcing a complete discharge of this capacitor. At the same time, the control module CM assigns a value one to a bit bₓ, if during charging the capacitor Cₓ by means of the reference current source I_{R}, charging of the next capacitor is not started by means of the signal current source Is. Otherwise the control module CM assigns a value zero to the bit bₓ. At the same time, the control module CM starts to measure another reference interval. To this end, the control module CM selects from the set of capacitors CS a capacitor C_{z}, whose capacitance is currently the highest among those capacitors Cₙ₋ᵣ₋₁, ..., C₀ of the set of capacitors CS that have not been charged yet. Next, the control module CM causes, by means of a signal from the control output P_{z}, switching a switch of the set S_{z} to first position, and therefore connecting the top plate of the capacitor C_{z} to the output of the reference current source I_{R} and thus starting charging this capacitor. These actions are repeated until a time instant t₃ of the reference time period RT measuring end.

At a time instant t₂ when the end of the converted time interval T is detected by the control module CM, signaled at the converted time interval input In, the control module CM starts a precise measurement of a signal time period ST by method of weight compensation (Fig. 2 and Fig. 3). First, the control module CM selects from the set of capacitors CS a capacitor C_{z}, whose capacitance is currently the highest among those capacitors Cₙ₋ᵣ₋₁, ..., C₀ of the set of capacitors CS that have not been charged yet. Next, the control module CM causes, by means of a signal from the control output P_{z}, switching a switch of the set S_{z} to third position, and therefore connecting the top plate of the capacitor C_{z} to an output of the signal current source Is. At the same time, by means of a signal from the signal output Ps, the control module CM causes turning on the signal current source Is. The control module CM starts to measure the reference interval. Signal voltage Us building up across the capacitor C_{y}, charged by the signal current source Is, is compared by the signal comparator Ks with the threshold voltage U_{TH}. When the signal voltage Us reaches the threshold voltage U_{TH}, then, based on the output signal of the signal comparator Ks, the control module CM terminates measuring the reference interval. To this end, the control module CM causes, by means of a signal from the control output P_{y}, switching a switch of a set S_{y} to second position, and therefore disconnecting a top plate of the capacitor C_{y} from the output of the signal current source Is and at the same time connecting the top plate of the capacitor C_{y} to the ground of the circuit, forcing a complete discharge of this capacitor. At the same time, the control module CM assigns a value one to a bit b_{y}, if, during charging the capacitor C_{y} by means of the signal current source Is, charging of another capacitor is started by means of the reference current source I_{R}. Otherwise the control module CM assigns a value zero to the bit b_{y}. At the same time, the control module CM starts to measure another reference interval. To this end, the control module CM selects from the set of capacitors CS a capacitor C_{z}, whose capacitance is currently the highest among those capacitors Cₙ₋ᵣ₋₁, ..., C₀ of the set of capacitors CS that have not been charged yet]. Next, the control module CM causes, by means of a signal from the control output P_{z}, switching a switch of the set S_{z} to third position, and therefore connecting the top plate of the capacitor C_{z} to the output of the signal current source Is and thus starting charging this capacitor. These actions are repeated until the time instant t₃ of the end of measuring the signal time period ST.

Measuring the reference time period RT and the signal time period ST is terminated by the control module CM at the time instant t₃ (Fig. 2 and Fig. 3), when during charging the capacitor C₀ with the lowest capacitance in the set of capacitors CS the control module CM detects either that the reference voltage U_{R} building up across the capacitor Cₓ charged by the reference current source I_{R} is equal to the threshold voltage U_{TH} based on the output signal of the reference comparator K_{R}, or that the signal voltage Us building up across the capacitor C_{y} charged by the signal current source Is is equal to the threshold voltage U_{TH} based on the output signal of the signal comparator Ks. The control module CM causes then, by means of a signal from the reference output P_{R}, switching off the reference current source I_{R} and simultaneously by means of a signal from the signal output P_{S} the control module CM causes switching off the signal current source Is. By means of signals from the control outputs Pₙ₋ᵣ₋₁, ..., P₀ the control module CM causes switching the switches of the set Sₙ₋ᵣ₋₁, ..., S₀ to second positions, and therefore connecting the top plates of all capacitors Cₙ₋ᵣ₋₁, ..., C₀ of the set of capacitors CS to the ground of the circuit, forcing a complete discharge of all capacitors Cₙ₋ᵣ₋₁, ..., C₀ of the set of capacitors CS. At the same time, the control module CM causes switching both counter switches Sₙ₋ᵣ to second position, and therefore connecting the top plates of both counter capacitors Cₙ₋ᵣ to the ground of the circuit, forcing a complete discharge of both counter capacitors Cₙ₋ᵣ. Next, the control module CM puts the complete conversion output RDY in active state. At the same time, the control module CM starts to monitor the state of the converted time interval input In in order to detect a beginning of the next converted time interval T.

A clockless and direct conversion of a time interval to a digital word, implemented according to the invention in a second exemplary apparatus, differs from the one implemented in the first exemplary apparatus in that during measuring the initial fragment SRT of the reference time period RT the control module CM keeps, by means of a signal from the reference output P_{R}, the efficiency of the reference current source I_{R} at a value 5 times lower than the efficiency of the signal current source Is. On the other hand, during measuring the final fragment ERT of the reference time period RT the control module CM keeps, by means of a signal from the reference output P_{R}, the efficiency of the reference current source I_{R} at a value equal to the efficiency of the signal current source Is.

### List of references in the drawing

- In: converted time interval input
- In_{S}: signal input
- In_{R}: reference input
- P_{S}: signal output
- P_{R}: reference output
- B: digital word output
- bₙ₋₁, ..., bᵣ: most significant bits of the output digital word
- bₙ₋ᵣ₋₁, ..., b₀: least significant bits of the output digital word
- RDY: complete conversion output
- Is: signal current source
- I_{R}: reference current source
- S: signal bus
- R: reference bus
- K_{S}: signal comparator
- K_{R}: reference comparator
- CS: set of capacitors
- Cₙ₋ᵣ₋₁, ..., C₀: capacitors of the capacitor set
- Cₙ₋ᵣ₋₁: capacitor having the highest capacitance in the set of capacitors
- C₀: capacitor having the lowest capacitance in the set of capacitors
- Cₙ₋ᵣ: counter capacitor
- Sₙ₋ᵣ₋₁, ..., S₀: switches of the set
- Sₙ₋ᵣ: counter switch
- Pₙ₋ᵣ₋₁, ..., P₀: control outputs
- Pₙ₋ᵣ: counter output
- CM: control module
- Ct: counter
- Us: signal voltage
- U_{R}: reference voltage
- U_{TH}: threshold voltage
- U_{DD}: supply voltage
- T: converted time interval
- t₁: time instant of detecting the beginning of the converted time interval T
- t₂: time instant of detecting the end of the converted time interval T
- t₃: time instant of the end of measuring the reference time period
- CI: counter interval
- ST: signal time period
- RT: reference time period
- SRT: initial fragment of the reference time period
- ERT: final fragment of the reference time period

## Claims

1. An apparatus for clockless and direct converting a time interval to a digital word, comprising a control module equipped with a converted time interval input, a complete conversion output, a reference input connected to an output of a reference comparator and a signal input connected to an output of a signal comparator and a reference output connected to a control input of a reference current source and a signal output connected to a control input of a signal current source, as well as control outputs connected to control inputs of switches of a set and an output of n-bit output digital word, comprising r most significant bits and n-r least significant bits, where r is a linearization degree, and furthermore a non-inverting input of the reference comparator is connected to a reference bus and to an output of the reference current source, whose input is connected to supply voltage, and an inverting input of the reference comparator is connected to threshold voltage, whereas a non-inverting input of the signal comparator is connected to a signal bus and to an output of the signal current source, whose input is connected to the supply voltage, and an inverting input of the signal comparator is connected to threshold voltage and to the inverting input of the reference comparator, wherein the set of capacitors comprises n-r capacitors, wherein capacitance of each subsequent capacitor of the set of capacitors is twice as low as the capacitance of its immediately preceding capacitor, whereas a bottom plate of each capacitor of the set of capacitors is connected to a ground of the circuit, and a top plate of each capacitor of the set of capacitors is connected to a moving contact of a switch of the set assigned to this capacitor, wherein a first stationary contact of each switch of the set is connected to the reference bus, a second stationary contact of each switch of the set is connected to the ground of the circuit, and a third stationary contact of each switch of the set is connected to the signal bus, **characterized in that** the control module (CM) comprises an r-bit counter (Ct), whose outputs are connected to outputs of r most significant bits (bₙ₋₁, ..., bₙ₋ᵣ) of the output digital word (B), and furthermore the control module (CM) is equipped with counter outputs (Pₙ₋ᵣ), each of which is connected to a control input of a different counter switch (Sₙ₋ᵣ), whereas to a moving contact of each counter switch (Sₙ₋ᵣ) a top plate of a different counter capacitor (Cₙ₋ᵣ) is connected, whereas a first stationary contact of each counter switch (Sₙ₋ᵣ) is connected to the reference bus R, and a second stationary contact of each counter switch (Sₙ₋ᵣ) is connected to the ground of the circuit, to which a bottom plate of each counter capacitor (Cₙ₋ᵣ) is also connected, wherein capacitance of each counter capacitor (Cₙ₋ᵣ) is the same.

2. The apparatus according to claim 1, **characterized in that** the linearization degree r is a natural number greater than one and less than the number n of bits (bₙ₋₁, ..., bₙ₋ᵣ, bₙ₋ᵣ₋₁, ..., b₀) of the output digital word (B).

3. The apparatus according to claim 2, **characterized in that** it comprises two counter capacitors (Cₙ₋ᵣ).

4. The apparatus according to claim 3, **characterized in that** efficiency of the reference current source (I_{R}) is the same as efficiency of the signal current source (I_{S}) and simultaneously capacitance of each counter capacitor (Cₙ₋ᵣ) is twice as high as capacitance of the capacitor (Cₙ₋ᵣ₋₁) with the highest capacitance in the set of capacitors (CS).

5. The apparatus according to claim 3, **characterized in that** efficiency of the reference current source (I_{R}) is controlled and kept by means of the control module (CM) at a value k-times lower than efficiency of the signal current source (I_{S}) or equal to the efficiency of the signal current source (I_{S}) and simultaneously capacitance of each counter capacitor (Cₙ₋ᵣ) is k-times lower than double capacitance of the capacitor (Cₙ₋ᵣ₋₁) with the highest capacitance in the set of capacitors (CS).
